# EUROPÄISCHE PATENTANMELDUNG

(11) **EP 2 019 434 A2**
(43) Veröffentlichungstag der Anmeldung: **28.01.2009**
(21) Anmeldenummer: 08104370.5
(22) Anmeldetag: 11.06.2008
(51) Int. Cl.: H01L 31/042

(54) **Anordnung von Solarzellen in einem Solarmodul**

(30) Priorität: 27.07.2007 DE 202007010590 U
(71) Anmelder: SCHÜCO International KG, 33609 Bielefeld (DE)
(72) Erfinder: Erban, Christof, 52134, Herzogenrath (DE)
(74) Vertreter: Dantz, Jan Henning

(57) **Zusammenfassung**

Solarmodul (1, 1') mit einer Vielzahl von einzelnen miteinander verbundenen Solarzellen (7, 8, 10, 11) mit gleicher Fläche, wobei zwischen den Solarzellen (7, 8, 10, 11) transparente oder transluzente Bereiche (13, 13') vorgesehen sind, wobei mindestens zwei unterschiedliche Formate von Solarzellen (7, 8, 10, 11) vorgesehen sind. Dadurch können die notwendigen Verbindungsleitungen zwischen den Solarzellen sehr kurz gehalten werden und es können vorbestimmte Muster erzeugt werden.

## Beschreibung

Die vorliegende Erfindung betrifft ein Solarmodul mit einer Vielzahl von einzelnen miteinander verbundenen Solarzellen mit gleicher Fläche, wobei zwischen den Solarzellen transparente oder transluzente Bereiche vorgesehen sind.

Es ist bekannt, einzelne Solarzellen in einem Zellenfeld miteinander zu verschalten, um ein Solarmodul herzustellen. Dabei kommen meist gleichgroße und gleichformatige, meist quadratische Zellen zum Einsatz, die miteinander verschaltet werden. Wenn solche Solarmodule an Fassaden oder Lichtdächern eingesetzt werden sollen, muss ein gewisser Abstand zwischen den einzelnen Solarzellen vorgesehen werden, damit die Räumlichkeiten nicht völlig abgedunkelt werden. Für ein optisch ansprechendes Erscheinungsbild soll möglichst eine homogene Ansicht bereitgestellt werden.

Ein gewisser Abstand zwischen den einzelnen Solarzellen führt jedoch zu dem Problem, dass die Verbindungsleitungen zwischen den Solarzellen einen erheblichen Energieverlust mit sich bringen. Durch die Abstände zwischen den einzelnen Solarzellen nimmt bei einem Solarmodul die elektrische Leistung proportional zum Anstieg der Transparenz ab. Je größer der transparente Anteil an einem Solarmodul ist, desto größer der Energieverlust.

Es ist daher Aufgabe der vorliegenden Erfindung ein Solarmodul zu schaffen, das einen hohen Wirkungsgrad und vorzugsweise auch geringen internen Verlusten aufweist und mit dem auch ein hohes Maß an Transparenz möglich ist.

Diese Aufgabe wird mit einem Solarmodul mit den Merkmalen des Anspruches 1 gelöst.

Erfindungsgemäß sind mindestens zwei unterschiedliche Formate von Solarzellen vorgesehen, so dass an einem Solarmodul ein gewisses Muster durch diese Solarzellen unterschiedlichen Formates erzeugt werden kann. Dabei besitzen die einzelnen Solarzellen die gleiche Fläche, aber sind geometrisch anders ausgebildet, entweder im Hinblick auf eine andere Form oder eine andere Ausrichtung. Dadurch können die notwendigen Verbindungsleitungen zwischen den Solarzellen sehr kurz gehalten werden, so dass trotz einer hohen Transparenz eine kurze Verbindung zwischen benachbarten Solarzellen vorhanden ist und die Energieverluste gering gehalten werden.

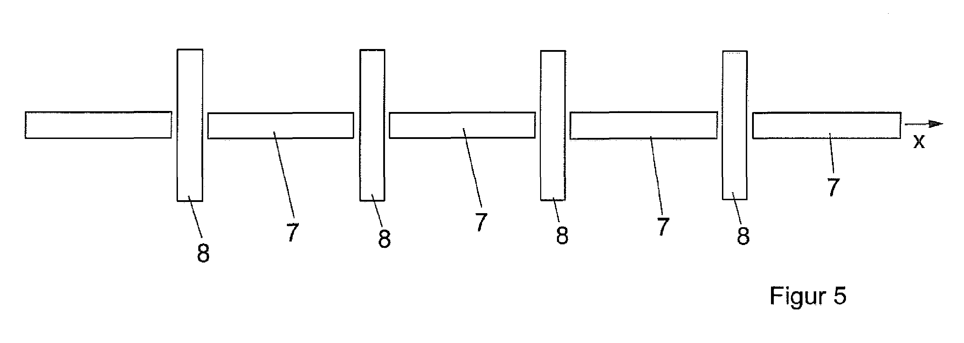

Vorzugsweise werden verschieden bzw. unterschiedlich formatige Solarzellen alternierend angeordnet. Derart wird besonders bevorzugt eine Reihung aus Solarzellen geschaffen, die sich in einer Richtung X erstreckt, wobei die Solarzellen wechselweise parallel zur Richtung X und senkrecht zur Richtung X ausgerichtet sind. Mit diesen Basisreihungen können dann flächige Anordnungen realisiert werden, wie sie z.B. in der Fig. 5 bis 9 dargestellt sind.

Gemäß einer bevorzugten Ausgestaltung der Erfindung besitzen die Solarzellen ein längliches Format und sind winklig zueinander angeordnet. Vorzugsweise können die Solarzellen dabei rechteckförmig sein, wobei ein Teil der Solarzellen im Hochformat und ein Teil der Solarzellen im Querformat angeordnet ist. Dadurch lässt sich eine netzartige Struktur der einzelnen Solarzellen herstellen, die ein regelmäßiges Erscheinungsbild aufweist. Eine solche netzartige Struktur wird auch optisch als ansprechend empfunden.

Um ein hohes Maß an Transparenz zu gewährleisten, sind die Solarzellen vorzugsweise mindestens doppelt so lang wie breit, so dass ein gewisser Abstand zwischen den Solarzellen vorhanden ist. Der transparente oder transluzente Bereich kann dabei mindestens 30 %, vorzugsweise mindestens 40 % der Gesamtfläche einnehmen. Um eine solche Transparenz oder Transluzenz bereitzustellen, sind die Solarzellen vorzugsweise zwischen zwei Glasplatten eingefasst.

Die Erfindung wird nachfolgend anhand zweier Ausführungsbeispiele mit Bezug auf die beigefügten Zeichnungen näher erläutert. Es zeigen:
- Figur 1: ein Solarmodul nach dem Stand der Technik;
- Figur 2: eine Ansicht eines Solarmoduls gemäß einem ersten Ausführungsbei- spiel;
- Figur 3: eine vergrößerte Ansicht des Solarmoduls der Figur 2, und
- Figur 4: eine vergrößerte Ansicht eines modifizierten Solarmoduls;
- Fig. 5 - 9: weitere schematische Darstellungen von Anordnungen von Solarzel- len in einem Solarmodul.

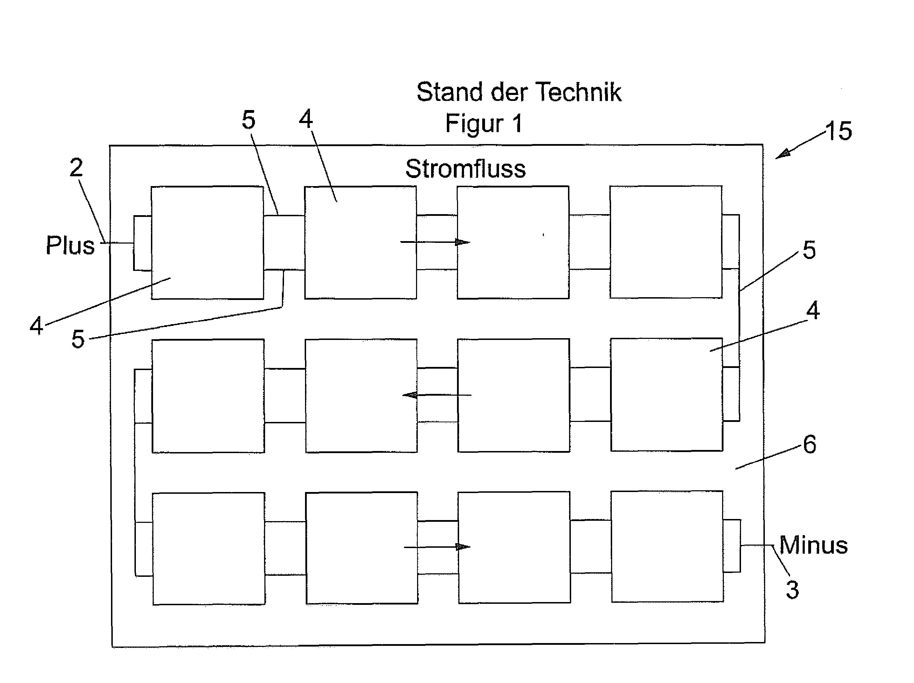

In Figur 1 ist ein Solarmodul 15 nach dem Stand der Technik gezeigt. Das bekannte Solarmodul umfasst einen ersten Anschluss, einen Plus-Anschluss 2 sowie einen zweiten Anschluss, einen Minus-Anschluss 3. Zwischen den Anschlüssen 2 und 3 ist eine Vielzahl von quadratischen Solarzellen 4 angeordnet, die über Verbindungsleitungen 5 miteinander verbunden sind. Um das Solarmodul 15 transparent oder transluzent auszugestalten, sind die Solarzellen 4 in einem Abstand zueinander angeordnet, so dass sich transparente oder transluzente Bereiche 6 ergeben. Aufgrund des Abstandes zwischen den Solarzellen 4 an den Verbindungsleitungen 5 ist jedoch der Wirkungsgrad eines solchen Solarmoduls niedrig.

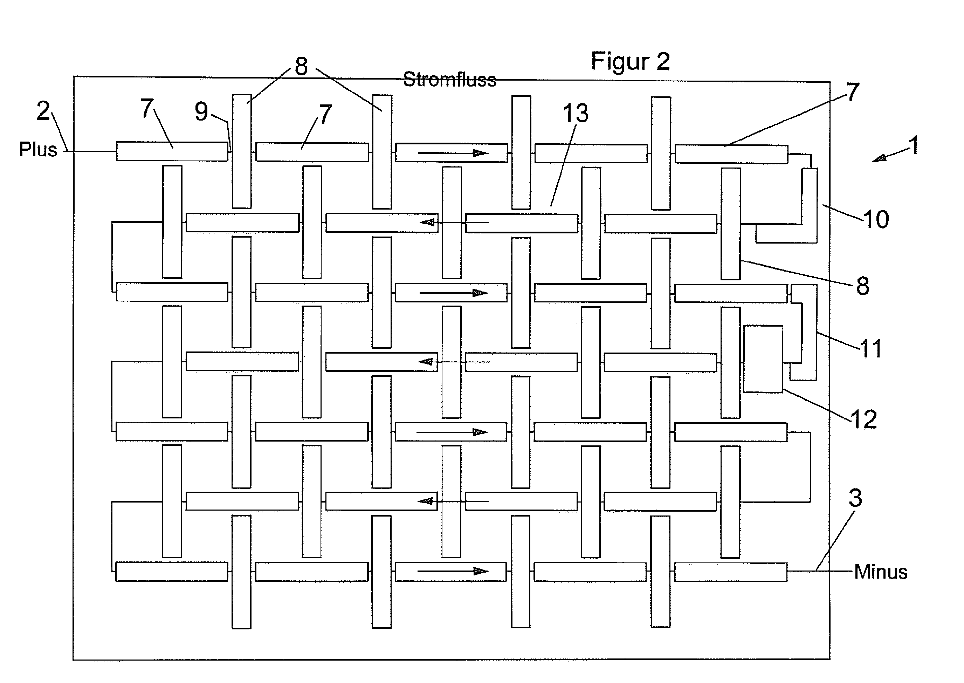

In Figur 2 ist ein erfindungsgemäßes Ausführungsbeispiel eines Solarmoduls 1 gezeigt, bei dem ein Plus-Anschluss 2 und ein Minus-Anschluss 3 vorgesehen sind. Zwischen dem Anschluss 2 und 3 sind eine Vielzahl von Solarzellen 7, 8, 10, 11 und 12 geschaltet, die sämtlich dieselbe Fläche besitzen, aber nicht gleich ausgerichtet sind. Die Solarzellen weisen vielmehr ein unterschiedliches Format auf. So sind die Solarzellen 7 und 8 rechteckig ausgebildet, wobei die Solarzellen 7 im Querformat und die Solarzellen 8 im Hochformat angeordnet sind. Mit anderen Worten ist die Längsrichtung der Solarzellen 7 senkrecht zu der Längsrichtung der Solarzellen 8 angeordnet. Die Solarzellen 7 und 8 sind über eine Verbindungsleitung 9 miteinander verbunden, die allerdings sehr kurz ausgebildet ist, da die Solarzellen 7 und 8 nahezu aneinander anstoßen.

Das Solarmodul 1 besitzt eine netzartige Struktur aufgrund der regelmäßigen Anordnung der Solarzellen 7 und 8. In einem Randbereich können auch andere Formate von Solarzellen eingesetzt werden, so ist beispielsweise eine L-förmige Solarzelle 10 vorgesehen, die eine Verbindung zwischen einer querformatigen Solarzelle 7 mit einer hochformatigen Solarzelle 8 schafft. Die Fläche der L-förmigen Solarzelle 10 ist gleich groß wie diejenige der rechteckigen Solarzellen 7 und 8.

Anstelle der L-förmigen Solarzelle 10 könnten auch zwei kleinere - zueinander L-förmig angeordnete - Solarzellen verwendet werden, solange die Summe der beiden kleineren Flächen gleich derjenigen der ursprünglich verwendeten Zelle ist.

Statt einer L-förmigen Solarzelle 10 kann auch in dem Übergangsbereich eine C-förmige Solarzelle 11 eingesetzt werden, die in dem Randbereich an die Kontur der benachbarten Solarzellen 8 angepasst ist.

Um gewisse unregelmäßige Abstände zu überbrücken, können auch weitere rechteckförmige Solarzellen 12 eingesetzt werden, die die gleiche Fläche haben wie die rechteckigen Solarzellen 7 und 8, allerdings ein anderes Verhältnis von Länge zu Breite.

Aufgrund der unterschiedlichen Formate der Solarzellen 7, 8, 10, 11 und 12 wird ein Solarmodul 1 bereitgestellt, das einen großen transparenten oder transluzenten Bereich 13 aufweist. Dabei sind die einzelnen Solarzellen zwischen zwei Glasscheiben eingefasst, so dass sich das Solarmodul 1 besonders gut für den Einbau an Gebäuden eignet.

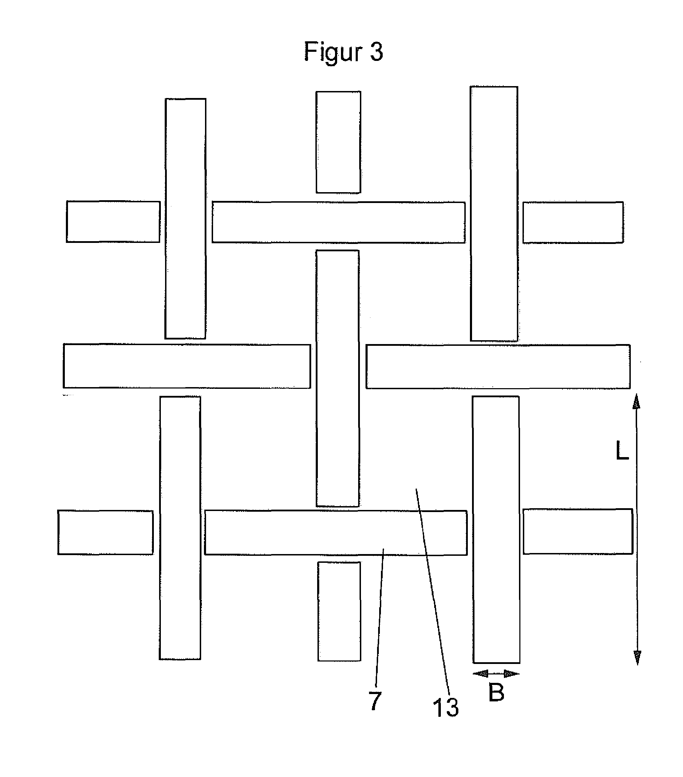

In Figur 3 ist das Solarmodul in einem gewissen Bereich vergrößert dargestellt, wobei erkennbar ist, dass die Solarzellen 7 und 8 in einem rechten Winkel zueinander angeordnet sind, wobei das Verhältnis von Länge L einer Solarzelle 8 zu deren Breite B etwa in einem Bereich 5 zu 1 liegt, vorzugsweise in einem Bereich zwischen 3 zu 1 und 6 zu 1. Dadurch lässt sich ein Solarmodul 1 schaffen, das ein hohes Maß an Transparenz bzw. Transluzenz aufweist, wobei die transparenten Bereiche 13 mindestens 30 %, vorzugsweise 40 % der Gesamtfläche einnehmen.

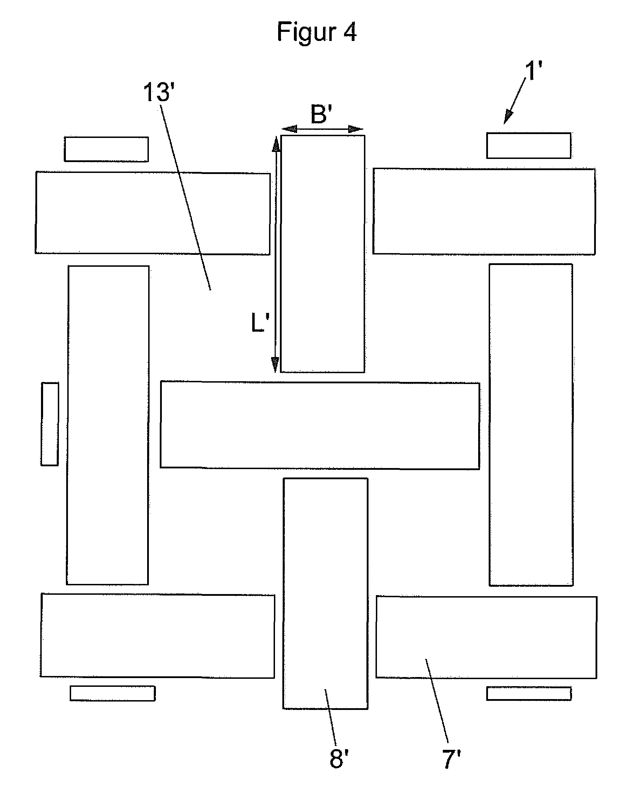

In Figur 4 ist ein modifiziertes Solarmodul 1' gezeigt, bei dem Solarzellen 7' und 8' eingesetzt werden, die ebenfalls rechteckförmig ausgebildet sind, allerdings eine nicht ganz so längliche Form besitzen. Eine Solarzelle 8 besitzt eine Länge L', die gegenüber einer Breite B' nur noch im Verhältnis etwa 3 zu 1 vorgesehen ist. Dadurch wird der transparente bzw. transluzente Bereich 13' verringert.

Die Verbindungsleitungen sind zwischen benachbarten Solarzellen relativ kurz, insbesondere kürzer als 1 cm.

Das in den Figuren dargestellte Prinzip der alternativen Formate ist auch nicht auf die dargestellten Formate begrenzt sondern auch in anderer Anordnung z.B. mit alternativ runden und elliptischen Solarzellen realisierbar.

Fig. 5 - 9 zeigen weitere schematische Darstellungen von Anordnungen von Solarzellen in einem Solarmodul.

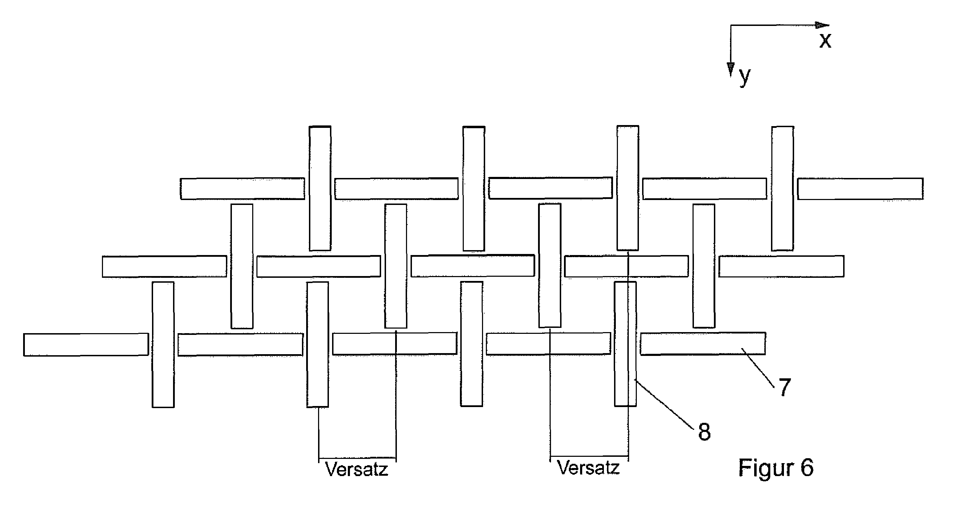

Danach werden auch hier Solarzellen länglicher rechteckiger Grundform in einer alternierenden Ausrichtung angeordnet. Derart wird besonders bevorzugt eine Reihung aus Solarzellen 7, 8 geschaffen, die sich in einer Richtung X erstreckt, wobei die Solarzellen 7, 8 wechselweise parallel zur Richtung X (hier vier Solarzellen 7) und senkrecht zur Richtung X (hier fünf Solarzellen 8) ausgerichtet sind. Mit diesen Basisreihungen bzw. "basic strings" können dann flächige Anordnungen realisiert werden, wie sie beispielhaft in Fig. 6 bis 9 dargestellt sind.

Fig. 6 zeigt ein Zellfeld eines Solarmoduls, das aus Reihungen nach Art der Fig. 5 realisierbar ist. Dieses besteht aus drei Reihungen nach Art der Fig. 5, wobei die Solarzellen 8 der verschiedenen Reihungen zueinander einen konstanten Versatz aufweisen und die Reihungen zahnartig ineinander greifen, so dass ein Muster realisiert wird, bei dem quadratische Flächen zwischen den Solarzellen 7, 8 frei bleiben. Der Abstand der Solarzellen 8 verschiedener Basisreihungen in X-Richtung ist dabei jeweils konstant. Der Abstand der Basisreihungen in Y-Richtung ist ebenfalls konstant.

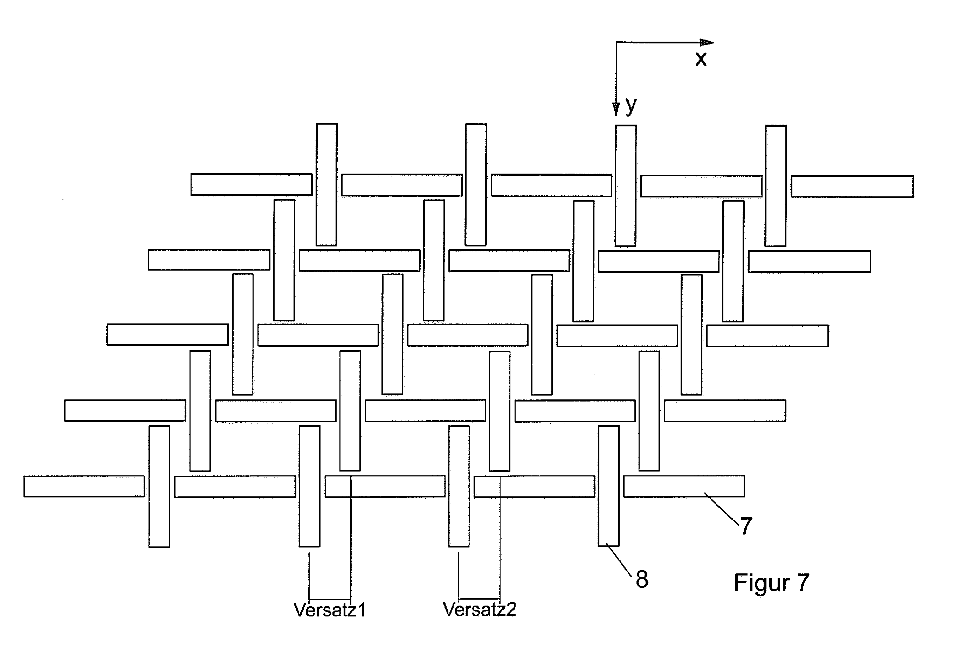

Fig. 7 zeigt ein weiteres Zellfeld eines Solarmoduls, das aus Reihungen nach Art der Fig. 5 realisierbar ist. Auch hier weisen die Solarzellen 8 der verschiedenen Reihungen zueinander einen konstanten Versatz auf und die Reihungen greifen zahnartig ineinander, so dass ein Muster realisiert wird, bei dem längliche rechteckige aber jeweils in Richtung +X und -X verschieden Flächen zwischen den Solarzellen 7, 8 frei bleiben. Der Abstand der Solarzellen 8 verschiedener Basisreihungen in X-Richtung ist dabei jeweils zwar konstant aber jeweils in Richtung +X und -X bzw. nach rechts und links ausgehend von jeder Solarzelle 8 verschieden. Der Abstand der Basisreihungen in Y-Richtung ist wiederum konstant.

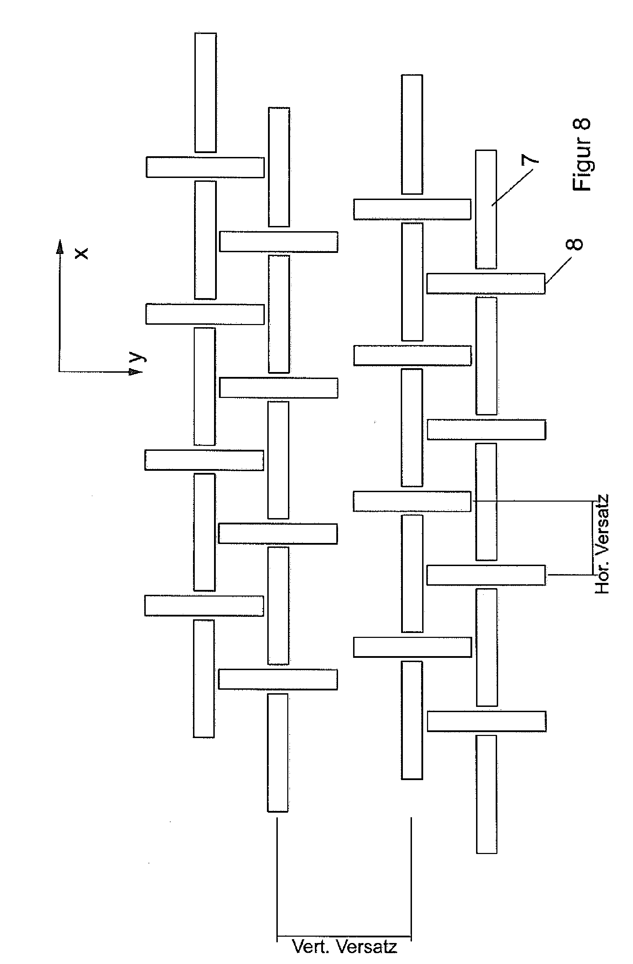

Fig. 8 zeigt ein weiteres Zellfeld eines Solarmoduls, das aus zwei doppelten Reihungen nach Art der Fig. 5 realisierbar ist. Auch hier weisen die Solarzellen 8 der verschiedenen Reihungen zueinander einen konstanten Versatz auf und die Reihungen greifen zahnartig ineinander, so dass ein Muster realisiert wird, bei dem rechteckige Flächen zwischen den Solarzellen 7, 8 frei bleiben. Der Abstand der Solarzellen 8 verschiedener Basisreihungen in X-Richtung ist dabei konstant. Der Abstand der Basisreihungen in Y-Richtung ist nicht konstant, so dass nicht symmetrische transparente Flächen verbleiben.

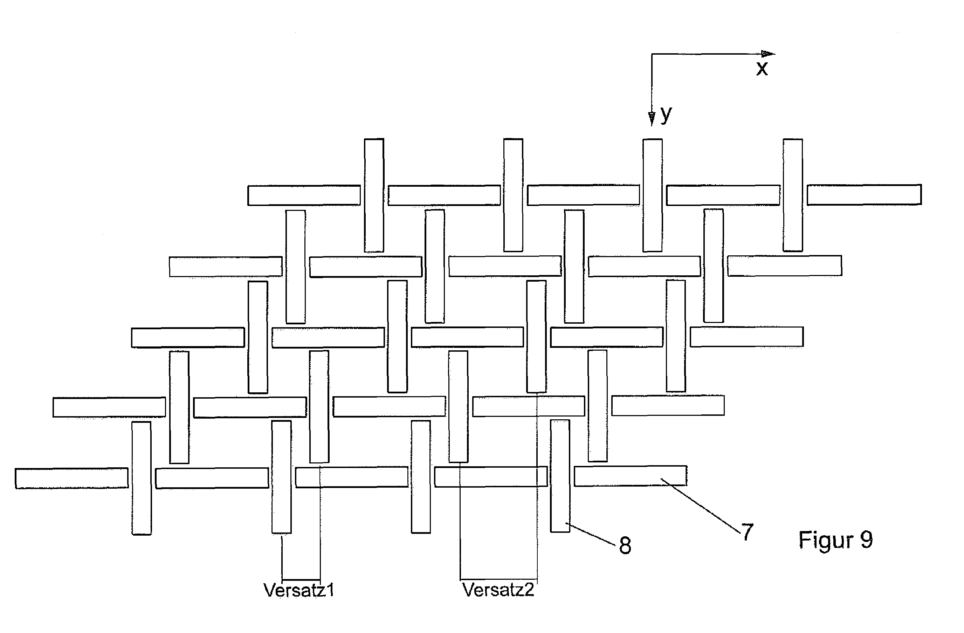

Fig. 9 zeigt ein weiteres Zellfeld eines Solarmoduls, das aus Reihungen nach Art der Fig. 5 realisierbar ist. Hier weisen die Solarzellen 8 der verschiedenen Reihungen einen unterschiedlichen Versatz (Versatz 1, Versatz 2) in X-Richtung zueinander auf, so dass wiederum nicht symmetrische transparente Flächen verbleiben.

## Patentansprüche

1. Solarmodul (1, 1') mit einer Vielzahl von einzelnen miteinander verbundenen Solarzellen (7, 8, 7', 8', 10, 11) mit gleicher Fläche, wobei zwischen den Solarzellen (7, 8, 7', 8', 10, 11) transparente oder transluzente Bereiche (13, 13') vorgesehen sind, **dadurch gekennzeichnet, dass** mindestens zwei unterschiedliche Formate von Solarzellen (7, 8, 7', 8', 10, 11) vorgesehen sind.

2. Solarmodul nach Anspruch 1, **dadurch gekennzeichnet, dass** die Solarzellen (7, 8, 7', 8', 10, 11) ein längliches Format besitzen und winklig zueinander angeordnet sind.

3. Solarmodul nach Anspruch 1 oder 2, **dadurch gekennzeichnet, dass** die Solarzellen (7, 8, 7', 8', 10, 11) rechteckförmig ausgebildet sind und ein Teil der Solarzellen im Hochformat und ein Teil der Solarzellen im Querformat angeordnet sind.

4. Solarmodul nach einem der Ansprüche 1 bis 3, **dadurch gekennzeichnet, dass** das die Länge der Solarzellen (7, 8, 7', 8', 10, 11) mindestens doppelt so lang ist, wie deren Breite.

5. Solarmodul nach einem der Ansprüche 1 bis 4, **dadurch gekennzeichnet, dass** die Solarzellen (7, 8, 7', 8', 10, 11) zu einer Netzstruktur miteinander verbunden sind.

6. Solarmodul nach einem der Ansprüche 1 bis 5, **dadurch gekennzeichnet, dass** die transparenten oder transluzenten Bereiche (13, 13') mindestens 30 %, vorzugsweise mindestens 40 % der Gesamtfläche einnehmen.

7. Solarmodul nach einem der Ansprüche 1 bis 6, **dadurch gekennzeichnet, dass** die transparenten oder transluzenten Bereiche (13, 13') einzelne quadratische Flächen aufweisen.

8. Solarmodul nach einem der Ansprüche 1 bis 7, **dadurch gekennzeichnet, dass** die Solarzellen (7, 8, 7', 8', 10, 11) zwischen zwei Glasplatten eingepasst sind.

9. Solarmodul nach einem der Ansprüche 1 bis 8, **dadurch gekennzeichnet, dass** die Solarzellen (7, 8, 7', 8', 10, 11) als kristalline Zellen ausgebildet sind.

10. Solarmodul nach einem der Ansprüche 1 bis 8, **dadurch gekennzeichnet, dass** die Solarzellen (7, 8, 7', 8', 10, 11) als Dünnschichtsolarzellen ausgebildet sind.
